# FASCICULE DE BREVET EUROPEEN

(11) **EP 3 660 926 B1**
(45) Date de publication et mention de la délivrance du brevet: **17.11.2021**
(21) Numéro de dépôt: 19211312.4
(22) Date de dépôt: 25.11.2019
(51) Int. Cl.: H01L 31/0224, H01B 1/14

(54) **PROCEDE DE FABRICATION D'UN CONTACT ELECTRIQUE POUR UNE CELLULE PHOTOVOLTAÏQUE**
HERSTELLUNGSVERFAHREN EINES ELEKTRISCHEN KONTAKTS FÜR EINE FOTOVOLTAIKZELLE
METHOD FOR MANUFACTURING AN ELECTRICAL CONTACT FOR A PHOTOVOLTAIC CELL

(30) Priorité: 27.11.2018 FR 1871934
(43) Date de publication de la demande: 03.06.2020
(73) Titulaire: Commissariat à l'Énergie Atomique et aux Énergies Alternatives, 75015 Paris (FR)
(72) Inventeur: BRUHAT, Elise, 38054 Grenoble Cedex 9 (FR); GRANGE, Bernadette, 38054 Grenoble Cedex 9 (FR)
(74) Mandataire: INNOV-GROUP

(56) Documents cités:
- WO-A1-2017/144555
- US-A1- 2013 042 912
- US-A1- 2014 175 340
- Aiji Wang: "Effects of doping and annealing on properties of ZnO films grown by atomic layer deposition", , 18 février 2015 (2015-02-18), XP055613295, Extrait de l'Internet: URL:https://www.ncbi.nlm.nih.gov/pmc/artic les/PMC4385034/ [extrait le 2019-08-15]

## Description

### Domaine technique

L'invention se rapporte au domaine technique de la fabrication d'un contact électrique pour une cellule photovoltaïque, à partir d'une pâte de sérigraphie formée sur une couche d'oxyde transparent conducteur.

L'invention trouve notamment son application pour les cellules photovoltaïques à hétérojonction, à homojonction, et tandem.

### Etat de la technique antérieure

Un procédé de fabrication envisagé dans l'état de la technique, notamment dans le document Untila et al., « Silicon-Based Photovoltaïcs : State of the Art and Main Lines of Development» (ci-après D1), Thermal Engineering, vol. 58, n°11, pp. 932-947, 2011 comporte les étapes successives :
a') prévoir une cellule photovoltaïque comportant :
   - une couche d'oxyde transparent conducteur ;
   - une pâte de sérigraphie, formée sur la couche d'oxyde transparent conducteur, et possédant une température de cuisson ;
b') appliquer un traitement thermique à la cellule photovoltaïque, à la température de cuisson, dans une enceinte environnée par un air ambiant ;
c') sortir la cellule photovoltaïque de l'enceinte de manière à exposer la cellule photovoltaïque à l'air ambiant.

La couche d'oxyde transparent conducteur assure le rôle d'électrode, et éventuellement possède une fonction antireflet. La pâte de sérigraphie, après cuisson, forme un contact électrique.

D1 mentionne (p. 937, col. droite, § « *Films of transparent conducting oxides.*») qu'un tel procédé n'est pas utilisé de manière industrielle car la couche d'oxyde transparent conducteur est incompatible avec la formation de contacts électriques par sérigraphie, nécessitant classiquement un recuit thermique à haute température, c'est-à-dire entre 800°C et 900°C (D1, p.937, col. gauche, l. 1-14).

Comme l'évoque le document Wang et al., « Effects of doping and annealing on properties of ZnO films grown by atomic layer deposition », Nanoscale Research Letters, 10 :75, 2015 (ci-après D2), cette incompatibilité est principalement due au fait que, lorsque l'étape b') est exécutée sous une atmosphère comportant de l'air ambiant, la résistivité de la couche d'oxyde transparent conducteur augmente considérablement (de l'ordre de 10⁴ pour du ZnO dopé à l'aluminium) à l'issue de l'étape c'), cf. D2, table 2.

D2 suggère comme solution d'exécuter l'étape b') sous une atmosphère contrôlée, constituée d'argon ou constituée de diazote. Une telle suggestion n'est pas entièrement satisfaisante dans la mesure où elle engendre une contrainte supplémentaire liée au maintien de la composition de l'enceinte durant l'exécution de l'étape b').

WO2017/144555 divulgue un procédé de fabrication d'un contact électrique pour une cellule photovoltaïque , comportant les étapes successives de prévoir une cellule photovoltaïque comportant une couche d'oxyde transparent conducteur ainsi qu'une pâte de sérigraphie, électriquement conductrice, et formée sur la couche d'oxyde transparent conducteur, la pâte de sérigraphie possédant une température de cuisson ; puis d'appliquer un traitement thermique à la cellule photovoltaïque, à la température de cuisson (600-900°C) ; et enfin de refroidir la cellule pendant une durée déterminée de manière à soumettre la cellule photovoltaïque à un gradient de température (supérieur à 600°C par minute).

### Exposé de l'invention

L'invention vise à remédier en tout ou partie aux inconvénients précités. A cet effet, l'invention a pour objet un procédé de fabrication d'un contact électrique pour une cellule photovoltaïque, comportant les étapes successives :
a) prévoir une cellule photovoltaïque comportant :
   - une couche d'oxyde transparent conducteur ;
   - une pâte de sérigraphie, électriquement conductrice, et formée sur la couche d'oxyde transparent conducteur, la pâte de sérigraphie possédant une température de cuisson ;
b) appliquer un traitement thermique à la cellule photovoltaïque, à la température de cuisson, dans une enceinte environnée par un air ambiant, et sous une atmosphère comportant de l'air ambiant ;
c) refroidir l'enceinte pendant une durée déterminée en fonction de la température de cuisson, de manière à soumettre la cellule photovoltaïque à un gradient de température inférieur ou égal à 100°C par minute, de préférence compris entre 3°C par minute et 30°C par minute ;
d) sortir la cellule photovoltaïque de l'enceinte de manière à exposer la cellule photovoltaïque à l'air ambiant.

Ainsi, un tel procédé selon l'invention permet, grâce à l'étape c), de pouvoir appliquer le traitement thermique lors de l'étape b) sous une atmosphère non-contrôlée comportant de l'air ambiant, et ce sans observer une augmentation rédhibitoire de la résistivité de la couche d'oxyde transparent conducteur à l'issue de l'étape d).

En effet, les inventeurs ont constaté de manière surprenante qu'un refroidissement lent de la cellule photovoltaïque, exécuté avant l'étape d), permet de contenir l'augmentation de la résistivité de la couche d'oxyde transparent conducteur, ce qui est impossible avec une sortie de la cellule photovoltaïque de l'enceinte rapidement (voire immédiatement) après la fin de l'étape b), c'est-à-dire après la cuisson de la pâte de sérigraphie.

Ces constatations sont surprenantes car il existe un préjugé technique selon lequel il serait préférable de sortir la cellule photovoltaïque de l'enceinte rapidement (voire immédiatement) après la cuisson de la pâte de sérigraphie afin d'éviter que les molécules de dioxygène de l'air ambiant, présentes dans l'enceinte, n'aient le temps de combler les lacunes électroniques de l'oxyde transparent conducteur, et par là-même augmentent la résistivité de l'oxyde transparent conducteur. En effet, comme évoqué dans D2 (p.9, 1.11-13), le traitement thermique de l'étape b) introduit des lacunes en oxygène dans l'oxyde transparent conducteur.

### Définitions

- Par « oxyde transparent conducteur », on entend un oxyde transparent dans le domaine visible (éventuellement dans le proche infrarouge), et électriquement conducteur.
- Par « pâte de sérigraphie », on entend une pâte adaptée pour être imprimée par sérigraphie. On parle également d'encre de sérigraphie.
- Par « température de cuisson », on entend :
   une température de frittage lorsque la pâte de sérigraphie comporte une matrice minérale -e.g. métallique-, ou
   une température de polymérisation lorsque la pâte de sérigraphie comporte une matrice organique -polymères thermodurcissables- avec une charge pouvant être métallique.
- Par « air ambiant », on entend l'air libre environnant l'enceinte comprenant un taux de dioxygène compris entre 15% et 30%.
- Par « atmosphère comportant de l'air ambiant », on entend que l'atmosphère de l'enceinte comporte (minoritairement, majoritairement ou exclusivement) des molécules d'air provenant de l'air libre environnant l'enceinte.
- Par « gradient de température », on entend le taux de variation temporelle de la température (exprimée par exemple en °C/minute) à laquelle est soumise la cellule photovoltaïque dans l'enceinte. Le gradient de température est exprimé en valeur absolue, s'agissant d'un refroidissement avec une variation temporelle de la température négative.

Le procédé selon l'invention peut comporter une ou plusieurs des caractéristiques suivantes.

Selon une caractéristique de l'invention, l'étape c) est exécutée en injectant un flux de gaz inerte, de préférence le diazote, dans l'enceinte.

Ainsi, un avantage procuré est de pouvoir contrôler le gradient de température lors de l'étape c).

Selon une caractéristique de l'invention, l'étape c) est exécutée de sorte que l'enceinte présente une température égale à la température de l'air ambiant à l'issue de l'étape c).

Le terme « égale » s'entend dans les tolérances usuelles liées aux conditions expérimentales de mesure de la température, et non comme une égalité stricte au sens mathématique du terme.

Ainsi, un avantage procuré est d'éviter de soumettre la cellule photovoltaïque à un choc thermique lors de l'étape d).

Selon une caractéristique de l'invention, la durée pendant laquelle est exécutée l'étape c) est comprise entre 20 minutes et 3 heures.

Ainsi, un avantage procuré est d'obtenir un refroidissement suffisamment lent de la cellule photovoltaïque pour contenir la résistivité de la couche d'oxyde transparent conducteur, et ce tout en n'augmentant pas excessivement la durée d'opération du procédé.

Selon une caractéristique de l'invention, le gradient de température auquel est soumise la cellule photovoltaïque lors de l'étape c) est constant.

Le terme « constant » s'entend dans les tolérances usuelles liées aux conditions expérimentales de l'obtention du gradient, et non comme une valeur constante stricte au sens mathématique du terme.

Ainsi, un avantage procuré est de pouvoir contrôler plus facilement le gradient de température, par exemple en injectant un flux de gaz inerte dans l'enceinte.

Selon une caractéristique de l'invention, le gradient de température auquel est soumise la cellule photovoltaïque lors de l'étape c) comporte des paliers.

La valeur du gradient de température est obtenue en moyennant la variation de température sur un intervalle de temps donné.

Selon une caractéristique de l'invention, le traitement thermique appliqué lors de l'étape b) est un recuit thermique.

Par « recuit thermique », on entend un traitement thermique comportant un cycle de chauffage comprenant :
- une première phase de montée graduelle d'une température de chauffage jusqu'à atteindre une valeur plateau,
- une deuxième phase où la température de chauffage conserve la valeur plateau,
- une troisième phase de refroidissement.

Selon une caractéristique de l'invention, la température de cuisson est comprise entre 100°C et 1000°C, de préférence comprise entre 150°C et 900°C.

Ainsi, on privilégiera une pâte de sérigraphie possédant :
- une température de cuisson basse (e.g. entre 150°C et 350°C), classiquement une pâte de sérigraphique à matrice organique, lorsque la cellule photovoltaïque possède une couche susceptible de se dégrader à haute température ;
- une température de cuisson élevée (e.g. entre 400°C et 900°C), classiquement une pâte de sérigraphie à matrice minérale, lorsque la cellule photovoltaïque ne possède pas de couche susceptible de se dégrader à haute température, et ce afin d'améliorer la qualité du contact électrique.

Selon une caractéristique de l'invention, l'atmosphère sous laquelle est appliqué le traitement thermique lors de l'étape b) comporte majoritairement de l'air ambiant.

Ainsi, un avantage procuré est de s'affranchir d'une atmosphère contrôlée de l'enceinte.

Selon une caractéristique de l'invention, la couche d'oxyde transparent conducteur est réalisée dans un matériau sélectionné parmi l'oxyde d'indium-étain, CuO, NiO, TiO, un oxyde de fluor dopé à l'étain, l'oxyde d'étain SnO₂, l'oxyde de zinc ZnO ; SnO₂ et ZnO étant de préférence respectivement dopés au fluor et à l'aluminium.

Selon une caractéristique de l'invention, la cellule photovoltaïque prévue lors de l'étape a) est choisie parmi une cellule à hétérojonction, une cellule à homojonction, une cellule tandem.

### Brève description des dessins

D'autres caractéristiques et avantages apparaîtront dans l'exposé détaillé de différents modes de réalisation de l'invention, l'exposé étant assorti d'exemples et de références aux dessins joints.

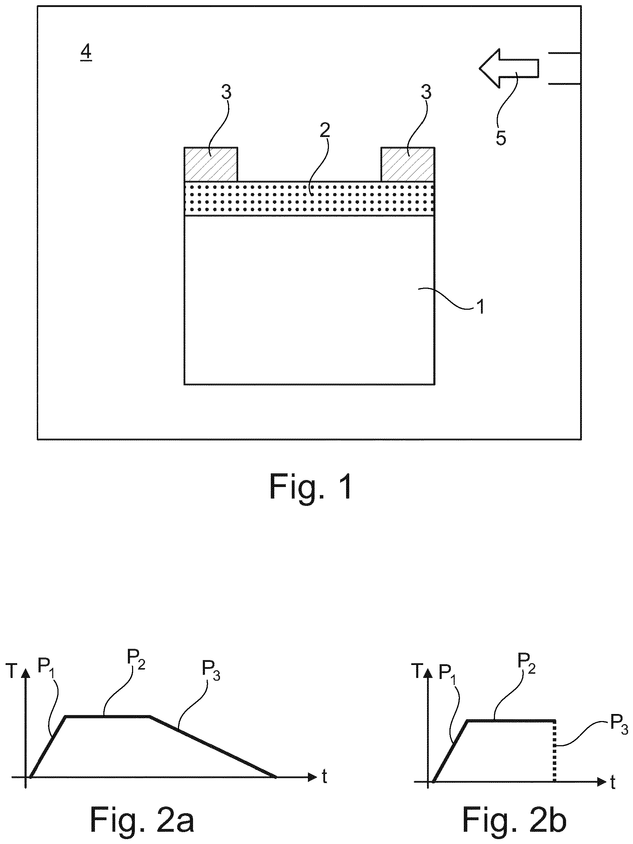

Figure 1 est une vue schématique en coupe illustrant une cellule photovoltaïque dans une enceinte où un procédé selon l'invention peut être mis en œuvre. Il est à noter que la figure 1 est schématique et n'est pas à l'échelle par souci de lisibilité.

Figures 2a et 2b sont des graphiques représentant en abscisses le temps (t) et en ordonnées la température (T) à laquelle est soumise la cellule photovoltaïque dans l'enceinte. Figure 2a illustre une évolution de la température dans un procédé selon l'invention lors des étapes b) et c), avec un refroidissement lent de la cellule photovoltaïque. Figure 2b illustre une évolution de la température dans un procédé selon l'état de la technique, où la cellule est retirée de l'enceinte immédiatement après l'étape b).

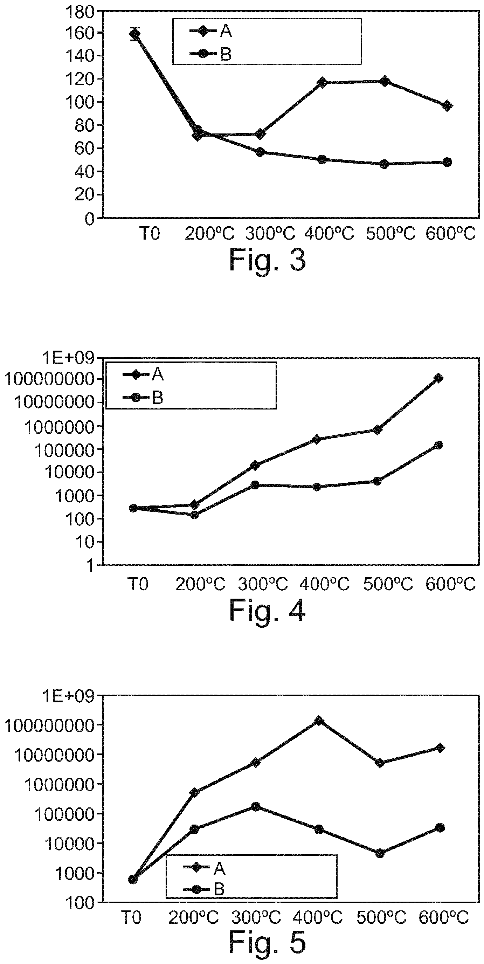

Figures 3 à 5 sont des graphiques représentant en abscisses la température du traitement thermique, et en ordonnées la résistance carrée (en Ω/□) d'une couche d'oxyde transparent conducteur formée sur un substrat de verre. T0 correspond à la température ambiante. Les séries de mesures « A » correspondent à l'application d'un profil de température illustré à la figure 2b. Les séries de mesures « B » correspondent à l'application d'un profil de température illustré à la figure 2a. L'oxyde transparent conducteur étudié à la figure 3 est l'oxyde d'indium-étain (ITO). L'oxyde transparent conducteur étudié à la figure 4 est l'oxyde de zinc, dopé à l'aluminium (AZO) déposé par pulvérisation cathodique magnétron (« *Magnetron sputtering* » en langue anglaise). L'oxyde transparent conducteur étudié à la figure 5 est (AZO) déposé par ALD (« *Atomic Layer Déposition* » en langue anglaise).

### Exposé détaillé des modes de réalisation

Les éléments identiques ou assurant la même fonction porteront les mêmes références pour les différents modes de réalisation, par souci de simplification.

Comme illustré à la figure 1, un objet de l'invention est un procédé de fabrication d'un contact électrique pour une cellule photovoltaïque 1, comportant les étapes successives :
a) prévoir une cellule photovoltaïque 1 comportant :
   - une couche 2 d'oxyde transparent conducteur ;
   - une pâte 3 de sérigraphie, électriquement conductrice, et formée sur la couche 2 d'oxyde transparent conducteur, la pâte 3 de sérigraphie possédant une température de cuisson ;
b) appliquer un traitement thermique à la cellule photovoltaïque 1, à la température de cuisson, dans une enceinte 4 environnée par un air ambiant, et sous une atmosphère comportant de l'air ambiant ;
c) refroidir l'enceinte 4 pendant une durée déterminée en fonction de la température de cuisson, de manière à soumettre la cellule photovoltaïque 1 à un gradient de température inférieur ou égal à 100°C par minute, de préférence compris entre 3°C par minute et 30°C par minute ;
d) sortir la cellule photovoltaïque 1 de l'enceinte 4 de manière à exposer la cellule photovoltaïque 1 à l'air ambiant.

### Cellule photovoltaïque

La cellule photovoltaïque 1 prévue lors de l'étape a) est avantageusement choisie parmi une cellule à hétérojonction (pn), une cellule à homojonction (pn), une cellule tandem. Cependant, le procédé selon l'invention peut être mis en œuvre pour tout type de cellule photovoltaïque, dès lors que la cellule photovoltaïque 1 comporte une couche 2 d'oxyde transparent conducteur formant une électrode. On peut citer par exemple les cellules photovoltaïques pérovskites (p-i-n), ou encore les cellules photovoltaïques organiques de type MIM (Métal-Isolant-Métal).

La couche 2 d'oxyde transparent conducteur est avantageusement réalisée dans un matériau sélectionné parmi l'oxyde d'indium-étain, CuO, NiO, TiO, un oxyde de fluor dopé à l'étain, l'oxyde d'étain SnO₂, l'oxyde de zinc ZnO ; SnO₂ et ZnO étant de préférence respectivement dopés au fluor et à l'aluminium.

La pâte 3 de sérigraphie est formée sur la couche 2 d'oxyde transparent conducteur, à travers un écran de sérigraphie délimitant les motifs des contacts électriques. La pâte 3 de sérigraphie peut être étalée sur l'écran de sérigraphie à l'aide d'une racle. La pâte 3 de sérigraphie peut comporter une matrice minérale métallique sous forme de poudre, par exemple en Ag ou en Al. La pâte 3 de sérigraphie peut alors être déposée sur l'écran de sérigraphie à l'aide d'un véhicule temporaire comportant classiquement un solvant, un liant, un plastifiant et un dispersant. Le véhicule temporaire disparaît lors de l'étape b). A titre de variante, la pâte 3 de sérigraphie peut comporter une matrice organique, réalisée dans un polymère thermodurcissable, et une charge métallique (e.g. en Ag ou Al). La matrice organique assure le rôle de véhicule permanent, conservé lors de l'étape b). On privilégiera une pâte 3 de sérigraphique à matrice organique, avec une température de cuisson basse (e.g. entre 150°C et 350°C), lorsque la cellule photovoltaïque 1 possède une couche susceptible de se dégrader à haute température (e.g. pour une cellule photovoltaïque 1 de type silicium à hétérojonction). De la même façon, on privilégiera une pâte 3 de sérigraphie à matrice minérale, avec une température de cuisson élevée (e.g. entre 400°C et 900°C), lorsque la cellule photovoltaïque ne possède pas de couche susceptible de se dégrader à haute température, afin d'obtenir un contact électrique de meilleure qualité.

### Traitement thermique de l'étape b)

Comme illustré à la figure 2a, le traitement thermique appliqué lors de l'étape b) est avantageusement un recuit thermique, comportant un cycle de chauffage comprenant :
- une première phase P₁ de montée graduelle d'une température de chauffage jusqu'à atteindre une valeur plateau,
- une deuxième phase P₂ où la température de chauffage conserve la valeur plateau,
- une troisième phase P₃ de refroidissement, exécutée lors de l'étape c).

La température de cuisson est avantageusement comprise entre 100°C et 1000°C, de préférence comprise entre 150°C et 900°C, correspondant à la valeur plateau de la deuxième phase P₂. Plus précisément, lorsque la pâte 3 de sérigraphie comporte une matrice minérale métallique sous forme de poudre, la température de cuisson correspond à la température de frittage (e.g. comprise entre 400°C et 900°C) permettant la cohésion de la matrice minérale. Lorsque la pâte 3 de sérigraphie comporte une matrice organique réalisée dans un polymère thermodurcissable, la température de cuisson correspond à la température de polymérisation du polymère thermodurcissable (e.g. comprise entre 150°C et 350°C) permettant la cohésion de la matrice organique.

Il est à noter que la température à laquelle est appliqué le traitement thermique de l'étape b) peut être variable, et non pas nécessairement fixe. Par exemple, la température à laquelle est appliqué le traitement thermique de l'étape b) peut comporter une succession de paliers et/ou de plateaux avec des valeurs croissantes de température.

Avantageusement, l'atmosphère sous laquelle est appliqué le traitement thermique lors de l'étape b) comporte majoritairement de l'air ambiant.

### Refroidissement de l'étape c)

L'étape c) est avantageusement exécutée en injectant un flux 5 de gaz inerte, de préférence le diazote, dans l'enceinte 4.

L'étape c) est avantageusement exécutée de sorte que l'enceinte 4 présente une température égale à la température de l'air ambiant à l'issue de l'étape c). Pour ce faire, la durée du refroidissement est déterminée en fonction de la température de cuisson et du gradient de température appliqué à la cellule photovoltaïque 1 de sorte que l'enceinte 4 présente une température égale à la température de l'air ambiant à l'issue de l'étape c). Selon une alternative, l'étape c) peut être exécutée de sorte que l'enceinte 4 présente une température inférieure ou égale à la moitié de la température de cuisson à l'issue de l'étape c). Pour ce faire, la durée du refroidissement est déterminée en fonction de la température de cuisson et du gradient de température appliqué à la cellule photovoltaïque 1 de sorte que l'enceinte 4 présente une température inférieure ou égale à la moitié de la température de cuisson à l'issue de l'étape c). Selon une alternative, l'étape c) peut être exécutée de sorte que l'enceinte 4 présente une température inférieure ou égale à 150°C, de préférence inférieure ou égale à 50°C à l'issue de l'étape c). Pour ce faire, la durée du refroidissement est déterminée en fonction de la température de cuisson et du gradient de température appliqué à la cellule photovoltaïque 1 de sorte que l'enceinte 4 présente la température souhaitée à l'issue de l'étape c).

La durée pendant laquelle est exécutée l'étape c) est avantageusement comprise entre 20 minutes et 3 heures.

Le gradient de température auquel est soumise la cellule photovoltaïque 1 lors de l'étape c) peut être constant. A titre de variante, le gradient de température auquel est soumise la cellule photovoltaïque 1 lors de l'étape c) peut comporter des paliers. Le gradient de température est avantageusement compris entre 0,5°C par minute et 100°C par minute, de préférence compris entre 3°C par minute et 30°C par minute.

### Expériences réalisées

Comme illustré aux figures 3 à 5, on peut constater qu'un refroidissement lent de la cellule photovoltaïque 1 (séries de mesures « B ») conduit à des résistivités nettement inférieures à celles observées lors d'un retrait brusque de la cellule photovoltaïque 1 hors de l'enceinte après l'étape b) (séries de mesures « A »).

Par ailleurs, si l'on note *ρ*₀ la résistivité initiale (à T0) de la couche 2 d'oxyde transparent conducteur, on constate que :
(i) la résistivité finale ne dépasse pas 2 ordres de grandeur (i.e. 10² *ρ*₀) pour l'ITO et l'AZO déposé par ALD, quelle que soit la température de recuit, cf. figures 3 et 5 ;
(ii) la résistivité finale ne dépasse pas 3 ordres de grandeur (i.e. 10³ *ρ*₀) pour l'AZO déposé par pulvérisation cathodique magnétron, quelle que soit la température de recuit, cf. figure 4 ;
(iii) la résistivité finale ne dépasse pas 2 ordres de grandeur (i.e. 10² *ρ*₀) pour l'AZO déposé par pulvérisation cathodique magnétron, pour les températures de recuit comprises entre 200°C et 500°C, cf. figure 4.

Ces résultats sont à comparer avec l'état de la technique (document D2) constatant un dépassement de 4 ordres de grandeur pour la résistivité finale.

On privilégiera une pâte 3 de sérigraphie avec une température de cuisson telle que la résistivité finale de la couche 2 d'oxyde transparent conducteur ne dépasse pas 2 ordres de grandeur.

## Revendications

1. Procédé de fabrication d'un contact électrique pour une cellule photovoltaïque (1), comportant les étapes successives :
a) prévoir une cellule photovoltaïque (1) comportant :
- une couche (2) d'oxyde transparent conducteur ;
- une pâte (3) de sérigraphie, électriquement conductrice, et formée sur la couche (2) d'oxyde transparent conducteur, la pâte (3) de sérigraphie possédant une température de cuisson ;
b) appliquer un traitement thermique à la cellule photovoltaïque (1), à la température de cuisson, dans une enceinte (4) environnée par un air ambiant, et sous une atmosphère comportant de l'air ambiant ;
c) refroidir l'enceinte (4) pendant une durée déterminée en fonction de la température de cuisson, de manière à soumettre la cellule photovoltaïque (1) à un gradient de température inférieur ou égal à 100°C par minute, de préférence compris entre 3°C par minute et 30°C par minute ;
d) sortir la cellule photovoltaïque (1) de l'enceinte (4) de manière à exposer la cellule photovoltaïque (1) à l'air ambiant.

2. Procédé selon la revendication 1, dans lequel l'étape c) est exécutée en injectant un flux (5) de gaz inerte, de préférence le diazote, dans l'enceinte.

3. Procédé selon la revendication 1 ou 2, dans lequel l'étape c) est exécutée de sorte que l'enceinte (4) présente une température égale à la température de l'air ambiant à l'issue de l'étape c).

4. Procédé selon l'une des revendications 1 à 3, dans lequel la durée pendant laquelle est exécutée l'étape c) est comprise entre 20 minutes et 3 heures.

5. Procédé selon l'une des revendications 1 à 4, dans lequel le gradient de température auquel est soumise la cellule photovoltaïque (1) lors de l'étape c) est constant.

6. Procédé selon l'une des revendications 1 à 4, dans lequel le gradient de température auquel est soumise la cellule photovoltaïque (1) lors de l'étape c) comporte des paliers.

7. Procédé selon l'une des revendications 1 à 6, dans lequel le traitement thermique appliqué lors de l'étape b) est un recuit thermique.

8. Procédé selon l'une des revendications 1 à 7, dans lequel la température de cuisson est comprise entre 100°C et 1000°C, de préférence comprise entre 150°C et 900°C.

9. Procédé selon l'une des revendications 1 à 8, dans lequel l'atmosphère sous laquelle est appliqué le traitement thermique lors de l'étape b) comporte majoritairement de l'air ambiant.

10. Procédé selon l'une des revendications 1 à 9, dans lequel la couche (2) d'oxyde transparent conducteur est réalisée dans un matériau sélectionné parmi l'oxyde d'indium-étain, CuO, NiO, TiO, un oxyde de fluor dopé à l'étain, l'oxyde d'étain SnO₂, l'oxyde de zinc ZnO ; SnO₂ et ZnO étant de préférence respectivement dopés au fluor et à l'aluminium.

11. Procédé selon l'une des revendications 1 à 10, dans lequel la cellule photovoltaïque (1) prévue lors de l'étape a) est choisie parmi une cellule à hétérojonction, une cellule à homojonction, une cellule tandem.

## Patentansprüche

1. Verfahren zur Herstellung eines elektrischen Kontaktes für eine Fotovoltaikzelle (1), umfassend die folgenden aufeinander folgenden Schritte:
a) Bereitstellen einer Fotovoltaikzelle (1), umfassend:
- eine Schicht (2) aus leitfähigem transparentem Oxid;
- eine Siebdruckpaste (3), die elektrisch leitfähig ist und auf der Schicht (2) aus leitfähigem transparentem Oxid gebildet ist, wobei die Siebdruckpaste (3) eine Brenntemperatur besitzt;
b) Anwenden einer thermischen Behandlung auf die Fotovoltaikzelle (1) bei der Brenntemperatur in einer von einer Umgebungsluft umgebenen Kammer (4) und unter einer Umgebungsluft umfassenden Atmosphäre;
c) Abkühlen der Kammer (4) während einer in Abhängigkeit von der Brenntemperatur bestimmten Dauer, so dass die Fotovoltaikzelle (1) einem Temperaturgradienten kleiner oder gleich 100 °C pro Minute, bevorzugt zwischen 3 °C pro Minute und 30 °C pro Minute unterzogen wird;
d) Entnehmen der Fotovoltaikzelle (1) aus der Kammer (4), so dass die Fotovoltaikzelle (1) der Umgebungsluft ausgesetzt wird.

2. Verfahren nach Anspruch 1, bei dem Schritt c) ausgeführt wird, indem ein Strom Inertgas (5), bevorzugt Distickstoff, in die Kammer eingeleitet wird.

3. Verfahren nach Anspruch 1 oder 2, bei dem Schritt c) so ausgeführt wird, dass die Kammer (4) eine Temperatur gleich der Temperatur der Umgebungsluft nach Schritt c) aufweist.

4. Verfahren nach einem der Ansprüche 1 bis 3, bei dem die Dauer, während der Schritt c) ausgeführt wird, zwischen 20 Minuten und 3 Stunden beträgt.

5. Verfahren nach einem der Ansprüche 1 bis 4, bei dem der Temperaturgradient, dem die Fotovoltaikzelle (1) bei Schritt c) unterzogen wird, konstant ist.

6. Verfahren nach einem der Ansprüche 1 bis 4, bei dem der Temperaturgradient, dem die Fotovoltaikzelle (1) bei Schritt c) unterzogen wird, Plateaus umfasst.

7. Verfahren nach einem der Ansprüche 1 bis 6, bei dem die in Schritt b) angewandte thermische Behandlung ein thermisches Glühen ist.

8. Verfahren nach einem der Ansprüche 1 bis 7, bei dem die Brenntemperatur zwischen 100 °C und 1000 °C, bevorzugt zwischen 150 °C und 900 °C liegt.

9. Verfahren nach einem der Ansprüche 1 bis 8, bei dem die Atmosphäre, unter der die thermische Behandlung bei Schritt b) angewandt wird, mehrheitlich Umgebungsluft umfasst.

10. Verfahren nach einem der Ansprüche 1 bis 9, bei dem die Schicht (2) aus leitfähigem transparentem Oxid aus einem Material ausgeführt ist, dass unter Indium-Zinn-Oxid, CuO, NiO, TiO, einem zinndotierten Fluoroxid, dem Zinnoxid SnO₂, dem Zinkoxid ZnO ausgewählt ist; wobei SnO₂ und ZnO bevorzugt jeweils fluor- und aluminiumdotiert sind.

11. Verfahren nach einem der Ansprüche 1 bis 10, bei dem die in Schritt a) bereitgestellte Fotovoltaikzelle (1) unter einer Zelle mit Heteroübergang, einer Zelle mit Homoübergang, einer Tandemzelle ausgewählt ist.

## Claims

1. Method for manufacturing an electrical contact for a photovoltaic cell (1), comprising the successive steps:
a) providing a photovoltaic cell (1) comprising:
- a layer (2) of transparent conductive oxide;
- an electrically conductive screen-printing slurry (3), formed on the layer (2) of transparent conductive oxide, the screen-printing slurry (3) having a curing temperature;
b) applying a heat treatment to the photovoltaic cell (1), at the curing temperature, in an enclosure (4) surrounded by ambient air, and in an atmosphere comprising ambient air;
c) cooling the enclosure (4) for a fixed time as a function of the curing temperature, so as to subject the photovoltaic cell (1) to a temperature gradient less than or equal to 100°C per minute, preferably between 3°C per minute and 30°C per minute;
d) removing the photovoltaic cell (1) from the enclosure (4) to expose the photovoltaic cell (1) to the ambient air.

2. Method according to Claim 1, wherein the step c) is executed by injecting a stream (5) of inert gas, preferably dinitrogen, into the enclosure.

3. Method according to Claim 1 or 2, wherein the step c) is executed in such a way that the enclosure (4) has a temperature equal to the temperature of the ambient air at the end of the step c).

4. Method according to one of Claims 1 to 3, wherein the time for which the step c) is executed is between 20 minutes and 3 hours.

5. Method according to one of Claims 1 to 4, wherein the temperature gradient to which the photovoltaic cell (1) is subjected in the step c) is constant.

6. Method according to one of Claims 1 to 4, wherein the temperature gradient to which the photovoltaic cell (1) is subjected in the step c) comprises levels.

7. Method according to one of Claims 1 to 6, wherein the heat treatment applied in the step b) is a thermal annealing.

8. Method according to one of Claims 1 to 7, wherein the curing temperature is between 100°C and 1000°C, preferably between 150°C and 900°C.

9. Method according to one of Claims 1 to 8, wherein the atmosphere in which the heat treatment is applied in the step b) comprises mostly ambient air.

10. Method according to one of Claims 1 to 9, wherein the layer (2) of transparent conductive oxide is produced in a material selected from among indium-tin oxide, CuO, NiO, TiO, a tin-oxide of fluorine, tin oxide SnO₂, zinc oxide ZnO; Sn0₂ and ZnO being preferably respectively doped with fluorine and with aluminium.

11. Method according to one of Claims 1 to 10, wherein the photovoltaic cell (1) provided in the step a) is chosen from among a heterojunction cell, a homojunction cell and a tandem cell.
